# EUROPEAN PATENT APPLICATION

(11) **EP 4 676 186 A1**
(43) Date of publication of application: **07.01.2026**
(21) Application number: 25182702.8
(22) Date of filing: 13.06.2025
(51) Int. Cl.: H10D 30/62, H10D 30/65

(54) **MULTIGATE SEMICONDUCTOR DEVICES WITH VARIED THRESHOLD VOLTAGE CHARACTERISTICS**

(30) Priority: 26.06.2024 US 202418754322
(71) Applicant: Avago Technologies International Sales Pte. Limited, Singapore 768923 (SG)
(72) Inventor: Ito, Akira, Irvine, CA, 92618 (US); Loo, Sim, San Diego, CA, 92130 (US)
(74) Representative: Grünecker Patent- und Rechtsanwälte PartG mbB

(57) **Abstract**

An example multigate semiconductor device with varied threshold voltages includes a channel, a source disposed on the channel, a drain disposed on the channel, a first gate disposed on the channel between the source and the drain, and a second gate disposed on the channel between the first gate and the drain. The first gate includes a first metal and the second gate includes a second metal, the second metal being different from the first metal.

## Description

### BACKGROUND

The present disclosure relates, in general, to semiconductor device technology. Semiconductor device structures including fin field-effect transistors (FinFET) and, more specifically, laterally diffused metal-oxide-semiconductors (LDMOS), can be used in high-power applications such as power amplifiers, radio frequency (RF) amplifiers, and power transistors for radio and wireless communication systems. As the demand for high-power applications increases, research and development efforts continue to advance semiconductor technologies to meet manufacturing capabilities and capacities of foundries and enhance the functionality of various electronic devices and circuits.

### BRIEF DESCRIPTION OF THE DRAWINGS

FIG. 1A shows a top view illustrating an example semiconductor device, in accordance with some aspects of the disclosure.
FIG. 1B shows a cross section view illustrating the example semiconductor device of FIG. 1A, in accordance with some aspects of the disclosure.
FIG. 2A shows a top view illustrating another example semiconductor device, in accordance with some aspects of the disclosure.
FIG. 2B shows a cross section view illustrating the example semiconductor device of FIG. 2A, in accordance with some aspects of the disclosure.
FIG. 3A shows a top view illustrating yet another example semiconductor device, in accordance with some aspects of the disclosure.
FIG. 3B shows a cross section view illustrating the example semiconductor device of FIG. 3A, in accordance with some aspects of the disclosure.
FIG. 4A shows a top view illustrating a further example semiconductor device, in accordance with some aspects of the disclosure.
FIG. 4B shows a cross section view illustrating the example semiconductor device of FIG. 4A, in accordance with some aspects of the disclosure.

### DETAILED DESCRIPTION

In the following description, for the purposes of explanation, numerous details are set forth to provide a thorough understanding of the disclosure. It will be apparent to one skilled in the art, however, that other aspects can be practiced without some details. Different examples are described herein, and while various features are ascribed to the examples, it should be appreciated that the features described with respect to one example may be incorporated with other examples as well. By the same token, however, no single feature or features of any described example should be considered essential to every example, as other examples may omit such features.

When an element is referred to herein as being "connected" or "coupled" to another element, it is to be understood that the elements can be directly connected to the other element, or have intervening elements present between the elements. In contrast, when an element is referred to as being "directly connected" or "directly coupled" to another element, it should be understood that no intervening elements are present in the "direct" connection between the elements. However, the existence of a direct connection does not exclude other connections, in which intervening elements may be present.

When an element is referred to herein as being "disposed" in some manner relative to another element (e.g., disposed on, disposed between, disposed under, disposed adjacent to, or disposed in some other relative manner), it is to be understood that the elements can be directly disposed relative to the other element (e.g., disposed directly on another element), or have intervening elements present between the elements. In contrast, when an element is referred to as being "disposed directly" relative to another element, it should be understood that no intervening elements are present in the "direct" example. However, the existence of a direct disposition does not exclude other examples in which intervening elements may be present.

Likewise, when an element is referred to herein as being a "layer", it is to be understood that the layer can be a single layer or include multiple layers. For example, a conductive layer can include multiple different conductive materials or multiple layers of different conductive materials, and a dielectric layer may comprise multiple dielectric materials or multiple layers of dielectric materials. When a layer is described as being coupled or connected to another layer, it is to be understood that the coupled or connected layers may include intervening elements present between the coupled or connected layers. In contrast, when a layer is referred to as being "directly" connected or coupled to another layer, it should be understood that no intervening elements are present between the layers. However, the existence of directly coupled or connected layers does not exclude other connections in which intervening elements may be present.

Moreover, the terms left, right, front, back, top, bottom, forward, reverse, clockwise and counterclockwise are used for purposes of explanation only and are not limited to any fixed direction or orientation. Rather, they are used merely to indicate relative locations and/or directions between various parts of an object and/or components.

Furthermore, unless otherwise indicated, all numbers used herein to express quantities, dimensions, and so forth should be understood as being modified in all instances by the term "about". In this application, the use of the singular includes the plural unless specifically stated otherwise, and use of the terms "and" and "or" means "and/or" unless otherwise indicated. Moreover, the use of the terms "including" and "having", as well as other forms, such as "includes", "included", "has", "have", and "had", should be considered non-exclusive. Also, terms such as "element" or "component" encompass both elements and components comprising one unit and elements and components that comprise more than one unit, unless specifically stated otherwise.

While some features and aspects have been described with respect to the examples, one skilled in the art will recognize that numerous modifications are possible. For example, the methods and processes described herein may be implemented using hardware components, custom integrated circuits (ICs), programmable logic, and/or any combination thereof. Further, while various methods and processes described herein may be described with respect to particular structural and/or functional components for ease of description, methods provided by various embodiments are not limited to any particular structural and/or functional architecture but instead can be implemented in any suitable hardware configuration. Similarly, while some functionality is ascribed to one or more system components, unless the context dictates otherwise, this functionality can be distributed among various other system components in accordance with the several embodiments.

Moreover, while the procedures of the methods and processes described herein are described in a particular order for ease of description, unless the context dictates otherwise, various procedures may be reordered, added, and/or omitted in accordance with various implementations. Moreover, the procedures described with respect to one method or process may be incorporated within other described methods or processes; likewise, system components described according to a particular structural architecture and/or with respect to one system may be organized in alternative structural architectures and/or incorporated within other described systems. Hence, while various examples are described with or without some features for ease of description and to illustrate aspects of those embodiments, the various components and/or features described herein with respect to a particular example can be substituted, added and/or subtracted from among other described embodiments, unless the context dictates otherwise. Consequently, although several examples are described above, it will be appreciated that the disclosure is intended to cover all modifications and equivalents within the scope of the following claims.

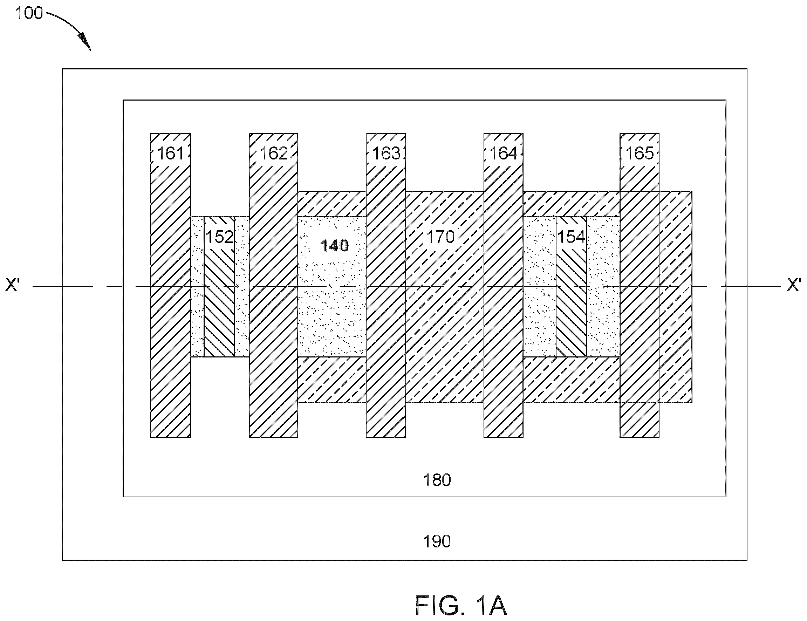

Referring to FIG. 1A, a top view illustrating an example semiconductor device 100 is shown, in accordance with some aspects of the disclosure. The semiconductor device 100 can be implemented as a variety of types of semiconductor devices, such as various different types and combinations of transistor structures. For example, the semiconductor device 100 can be a non-planar (three-dimensional) FinFET device such as, for example, an LDMOS device. As shown in FIG. 1A, the semiconductor device 100 includes an example channel 140. The channel 140 can be implemented in a variety of ways using a variety suitable materials and/or combinations of materials. For example, the channel 140 can include a conductive silicon fin in implementations where the semiconductor device 100 is a FinFET device. The channel 140 can also include any other suitable type of conductive fin or other channel-type structure used in the semiconductor device 100. The semiconductor device 100 is also shown to include a plurality of gates including a gate 161, a gate 162, a gate 163, a gate 164, and a gate 165. The semiconductor device 100 is further shown to include a source 152, a drain 154, and a trench 170 formed in the channel 140 and between the gate 163 and the drain 154. The semiconductor device 100 is also shown to include an oxide diffusion layer 190 (e.g., a thick oxide layer, etc.) and a doped layer 180 (e.g., an N+ buried layer, a deep n-well layer, etc.).

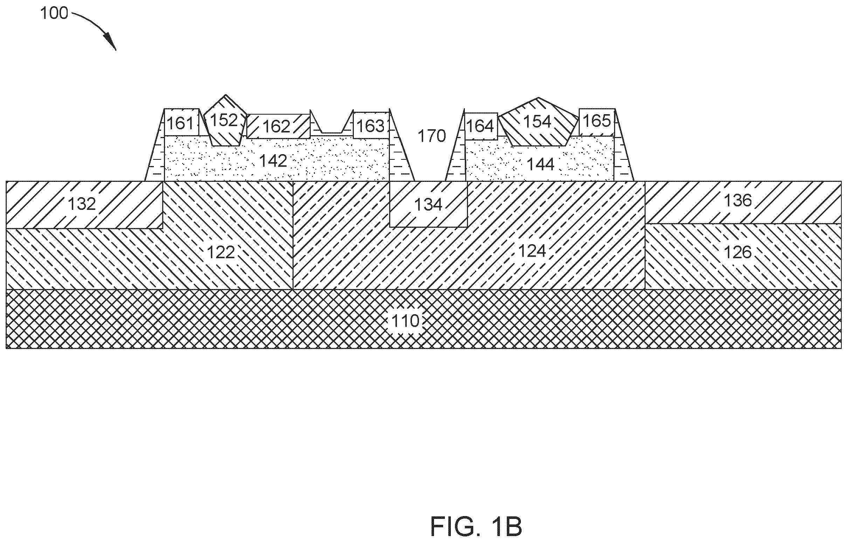

Referring to FIG. 1B, a cross section view illustrating the example semiconductor device 100 is shown, in accordance with some aspects of the disclosure. The illustrated cross section of the semiconductor device 100 as shown in FIG. 1B can be taken along the line X' as shown in FIG. 1A, for example. In the cross section of the semiconductor device 100 as shown in FIG. 1B, the source 152, the drain 154, the gate 161, the gate 162, the gate 163, the gate 164, and the gate 165 can all be seen. Additionally, the trench 170 can be seen, where the trench 170 is formed between two separate regions of the channel 140: a channel region 142 and a channel region 144. In the cross section of the semiconductor device 100 as shown in FIG. 1B, additional layers can also be seen, including a substrate 110, a p-type well 122, an n-type well 124, a p-type well 126, an isolation structure 132, an isolation structure 134, an isolation structure 136, and various oxide layers (e.g., gate oxide layers, etc.) formed around and/or between the source 152, the drain 154, the gate 161, the gate 162, the gate 163, the gate 164, the gate 165, the channel region 142, and the channel region 144.

The substrate 110 can be formed of silicon material (e.g., crystalline silicon) and/or other suitable materials or combinations of materials. The substrate 110 can be implemented using various fabrication technologies, such as using a silicon-on-insulator (SOI) structure, a bulk semiconductor structure, an alloy semiconductor, a compound semiconductor, germanium, and/or various other suitable materials and combinations thereof. The substrate 110 can generally provide a base for forming components of the semiconductor device 100 thereon. The semiconductor device 100 can be implemented in a variety of different types of circuits, inducing various types of integrated circuit (IC) chips built on various types of substrates.

The p-type well 122 and the p-type well 126 can be regions of the semiconductor device 100 that are doped using one or more suitable p-type dopants such as, for example, boron and/or other p-type dopants. The n-type well 124 can be a region of the semiconductor device 100 that is doped using one or more suitable n-type dopants such as arsenic, phosphorous, and/or other n-type dopants. The p-type well 122, the n-type well 124, and the p-type well 126 can be regions of the substrate 110 such that the p-type well 122, the n-type well 124, and the p-type well 126 include doped silicon material, for example. The p-type well 122, the n-type well 124, and the p-type well 126 can also be formed at least partially separate from the substrate 110. For example, the p-type well 122, the n-type well 124, and the p-type well 126 can be formed at least partially within various types of oxide layers and/or other insulating/dielectric layers of the semiconductor device 100. Notably, as shown in FIG. 1B, the isolation structure 134, the gate 163, and the trench 170 can be disposed over the n-type well 124. As a result of this structure, the region of the semiconductor device 100 between the gate 163 and the gate 164 can serve as a depletion region. The depletion region within the semiconductor device 100 can deplete charge carriers and thereby limit the amount of current that can flow through the depletion region, enabling the semiconductor device 100 to operate under higher voltage conditions. The doping polarities of the p-type well 122, the n-type well 124, and the p-type well 126 can be reversed in some applications (e.g., to provide a PLDMOS device instead of an LDMOS device).

The isolation structure 132, the isolation structure 134, and the isolation structure 136 can be shallow trench isolation (STI) structures, for example, among other possible types of dielectric layers. The isolation structure 132, the isolation structure 134, and the isolation structure 136 can be formed as a result of etching trenches in the semiconductor device 100. For example, after etching the trench 170 in the channel 140 and the n-type well 124, the isolation structure 134 can be formed by depositing a dielectric material at least partially within the trench 170. The dielectric material used to form the isolation structure 132, the isolation structure 134, and the isolation structure 136 can be, for example, silicon oxide, silicon nitride, and/or other suitable materials and combinations of materials. The isolation structure 132, the isolation structure 134, and the isolation structure 136 can prevent leakage of electric current between various components of the semiconductor device 100, for example.

The source 152 and the drain 154 can be implemented as epitaxial layers as part of the semiconductor device 100. For example, the source 152 and the drain 154 can be formed using various types of epitaxy processes and a variety of suitable epitaxial materials. The epitaxial materials can include, for example, silicon, gallium arsenide, and/or other suitable epitaxial materials and combinations thereof. In some examples, the source 152 and/or the drain 154 can be doped using suitable n-type or p-type dopants. Ultimately, the source 152 can be used to form a source terminal of a transistor (e.g., after forming a silicide layer and an interconnect on the epitaxial layer, etc.) and the drain 154 can be used to form a drain terminal of a transistor (e.g., after forming a silicide layer and an interconnect on the epitaxial layer, etc.). The source 152 can be disposed on the channel 140 between the gate 161 and the gate 162, and the drain 154 can be disposed on the channel 140 between the gate 164 and the gate 165. The source 152 and/or the drain 154 can be disposed directly on the channel 140 or there can be some materials and/or layers between the source 152 and/or the drain 154 and the channel 140.

In the semiconductor device 100, the gate 162 and the gate 163 can both be implemented as active gates such that the semiconductor device 100 is a multigate (split gate) device. That is, bias voltages that are applied at the gate 162 and the gate 163 can generally control operation and conductance of the semiconductor device 100. Then, in contrast, the gate 161, the gate 164, and the gate 165 can be implemented as "dummy" gates that are not active components of the semiconductor device 100, but can provide advantages in terms of the fabrication process for and the performance of the semiconductor device 100. The gate 161, the gate 164, and the gate 165 can be formed using polysilicon material and/or another suitable material or combination of materials.

The width of the gate 162 (as measured in the direction between the gate 161 and the gate 163 as shown in FIG. 1A) can be greater than the width of the gate 161, the width of the gate 164, and the width of the gate 165. Similarly, the width of the gate 163 (as measured in the direction between the gate 162 and the gate 164 as shown in FIG. 1A) can be greater than the width of the gate 161, the width of the gate 164, and the width of the gate 165. To provide advantages in terms of performance and durability, the width of the gate 162 and the width of the gate 163 can be between 50 nanometers and 360 nanometers, and the width of the gate 161, the width of the gate 164, and the width of the gate 165 can be between 50 nanometers and 100 nanometers. The gate 161, the gate 162, the gate 163, the gate 164, and the gate 165 can be disposed directly on the channel 140 or there can be some materials and/or layers between the gate 161, the gate 162, the gate 163, the gate 164, and the gate 165 and the channel 140 (e.g., gate oxide layers, etc.).

Relative to the semiconductor device 100, some alternate device structures may suffer from durability issues due to factors such as hot carrier injection (HCI) degradation, for example, among other possible factors. The durability issues can cause the overall device performance to degrade over time, and the durability issues can become even more prevalent especially as process node sizes continue to decrease with improvements in semiconductor fabrication technology. Moreover, as a result of process limitations associated with semiconductor fabrication technology (e.g., limitations of semiconductor fabrication plants), some approaches to improving device durability such as increasing channel length may not be feasible in various applications. However, the specific structure of the semiconductor device 100 can provide advantages in terms of improved durability relative to some alternate structures.

Notably, in the semiconductor device 100, the gate 162 can include and/or can be formed using a first metal, whereas the gate 163 can include and/or can be formed using a second metal that is different from the first metal. The second metal can be different from the first metal such that the gate 162 has a first threshold voltage (V_{T1}) and the gate 163 has a second threshold voltage (V_{T2}), where the second threshold voltage is greater than the first threshold voltage. This variance of the first threshold voltage and the second threshold voltage can alter the current flow and electrical fields within the semiconductor device 100 when compared to some alternate device structures in a manner that improves the durability of the semiconductor device 100. The first threshold voltage and the second threshold voltage can be the threshold bias voltage levels required to be applied to the gate 162 and the gate 163, respectively, to transition the semiconductor device 100 from an off state to an on state (e.g., the voltage levels required for current to flow through the semiconductor device 100).

By increasing the second threshold voltage relative to the first threshold voltage, the durability of the semiconductor device 100 (especially under higher operating voltage conditions) can be improved by reducing the effects of HCI degradation and/or other undesirable degradation effects that may otherwise occur. The second threshold voltage can be altered using the second metal in a variety of suitable manners. For example, the gate 163 can include a work function metal (e.g., the second metal) that increases the second threshold voltage relative to the first threshold voltage. The gate 163 can also be formed using an entirely different metal than the gate 162 in some implementations. The first metal can include molybdenum nitride, molybdenum, aluminum, tungsten nitride, titanium nitride, or tantalum nitride, for example. The second metal likewise can include molybdenum nitride, molybdenum, aluminum, tungsten nitride, titanium nitride, or tantalum nitride, for example.

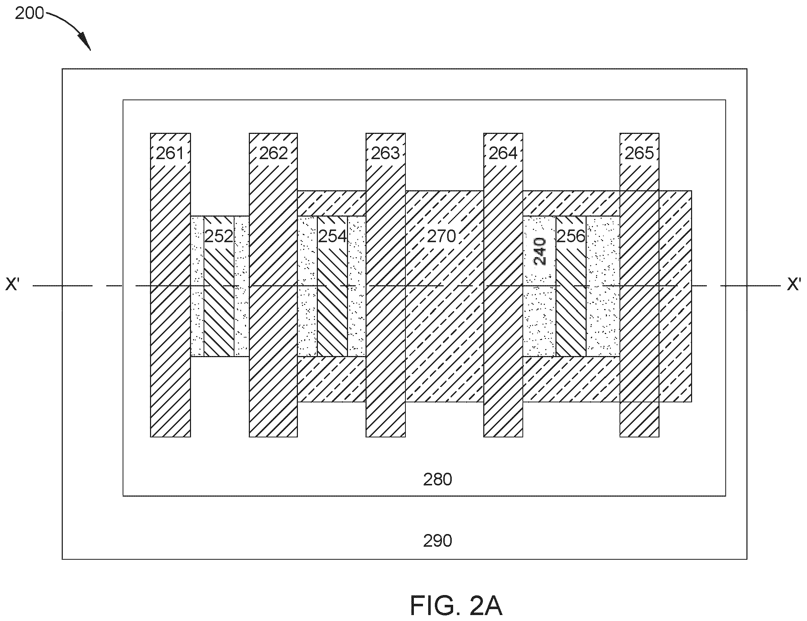

Referring to FIG. 2A, a top view illustrating another example semiconductor device 200 is shown, in accordance with some aspects of the disclosure. The semiconductor device 200 can be implemented as a variety of types of semiconductor devices, such as various different types and combinations of transistor structures. For example, the semiconductor device 200 can be a non-planar (three-dimensional) FinFET device such as, for example, an LDMOS device. As shown in FIG. 2A, the semiconductor device 200 includes an example channel 240. The channel 240 can be implemented in a variety of ways using a variety suitable materials and/or combinations of materials. For example, the channel 240 can include a conductive silicon fin in implementations where the semiconductor device 200 is a FinFET device. The channel 240 can also include any other suitable type of conductive fin or other channel-type structure used in the semiconductor device 200. The semiconductor device 200 is also shown to include a plurality of gates including a gate 261, a gate 262, a gate 263, a gate 264, and a gate 265. The semiconductor device 200 is further shown to include a source 252, an epitaxial layer 254, a drain 256, and a trench 270 formed in the channel 240 and between the gate 263 and the drain 256. The semiconductor device 200 is also shown to include an oxide diffusion layer 290 (e.g., a thick oxide layer, etc.) and a doped layer 280 (e.g., an N+ buried layer, a deep n-well layer, etc.).

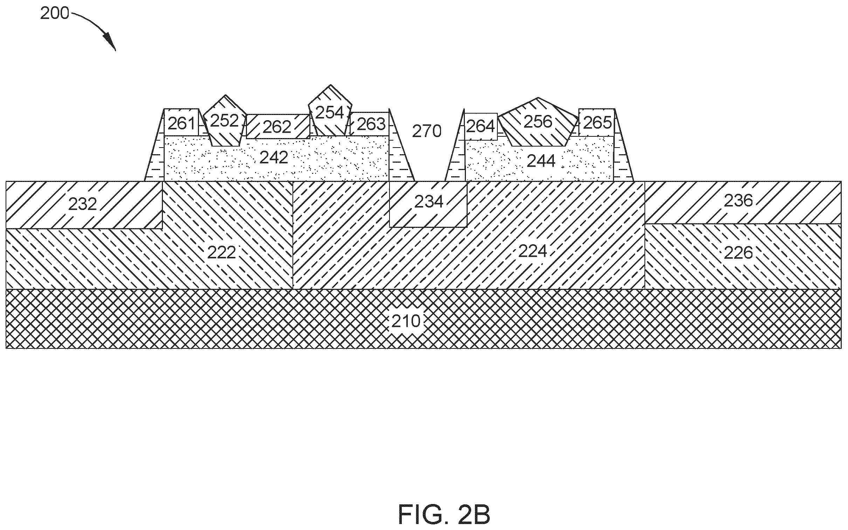

Referring to FIG. 2B, a cross section view illustrating the example semiconductor device 200 is shown, in accordance with some aspects of the disclosure. The illustrated cross section of the semiconductor device 200 as shown in FIG. 2B can be taken along the line X' as shown in FIG. 2A, for example. In the cross section of the semiconductor device 200 as shown in FIG. 2B, the source 252, the epitaxial layer 254, the drain 256, the gate 261, the gate 262, the gate 263, the gate 264, and the gate 265 can all be seen. Additionally, the trench 270 can be seen, where the trench 270 is formed between two separate regions of the channel 240: a channel region 242 and a channel region 244. In the cross section of the semiconductor device 200 as shown in FIG. 2B, additional layers can also be seen, including a substrate 210, a p-type well 222, an n-type well 224, a p-type well 226, an isolation structure 232, an isolation structure 234, an isolation structure 236, and various oxide layers (e.g., gate oxide layers, etc.) formed around and/or between the source 252, the epitaxial layer 254, the drain 256, the gate 261, the gate 262, the gate 263, the gate 264, the gate 265, the channel region 242, and the channel region 244.

The substrate 210 can be formed of silicon material (e.g., crystalline silicon) and/or other suitable materials or combinations of materials. The substrate 210 can be implemented using various fabrication technologies, such as using an SOI structure, a bulk semiconductor structure, an alloy semiconductor, a compound semiconductor, germanium, and/or various other suitable materials and combinations thereof. The substrate 210 can generally provide a base for forming components of the semiconductor device 200 thereon. The semiconductor device 200 can be implemented in a variety of different types of circuits, inducing various types of IC chips built on various types of substrates.

The p-type well 222 and the p-type well 226 can be regions of the semiconductor device 200 that are doped using one or more suitable p-type dopants such as, for example, boron and/or other p-type dopants. The n-type well 224 can be a region of the semiconductor device 200 that is doped using one or more suitable n-type dopants such as arsenic, phosphorous, and/or other n-type dopants. The p-type well 222, the n-type well 224, and the p-type well 226 can be regions of the substrate 110 such that the p-type well 222, the n-type well 224, and the p-type well 226 include doped silicon material, for example. The p-type well 222, the n-type well 224, and the p-type well 226 can also be formed at least partially separate from the substrate 110. For example, the p-type well 222, the n-type well 224, and the p-type well 226 can be formed at least partially within various types of oxide layers and/or other insulating/dielectric layers of the semiconductor device 200. Notably, as shown in FIG. 2B, the isolation structure 234, the gate 263, and the trench 270 can be disposed over the n-type well 224. As a result of this structure, the region of the semiconductor device 200 between the gate 263 and the gate 264 can serve as a depletion region. The depletion region within the semiconductor device 200 can deplete charge carriers and thereby limit the amount of current that can flow through the depletion region, enabling the semiconductor device 200 to operate under higher voltage conditions. The doping polarities of the p-type well 222, the n-type well 224, and the p-type well 226 can be reversed in some applications (e.g., to provide a PLDMOS device instead of an LDMOS device).

The isolation structure 232, the isolation structure 234, and the isolation structure 236 can be STI structures, for example, among other possible types of dielectric layers. The isolation structure 232, the isolation structure 234, and the isolation structure 236 can be formed as a result of etching trenches in the semiconductor device 200. For example, after etching the trench 270 in the channel 240 and the n-type well 224, the isolation structure 234 can be formed by depositing a dielectric material at least partially within the trench 270. The dielectric material used to form the isolation structure 232, the isolation structure 234, and the isolation structure 236 can be, for example, silicon oxide, silicon nitride, and/or other suitable materials and combinations of materials. The isolation structure 232, the isolation structure 234, and the isolation structure 236 can prevent leakage of electric current between various components of the semiconductor device 200, for example.

The source 252 and the drain 256 can be implemented as epitaxial layers as part of the semiconductor device 200, along with the epitaxial layer 254. The source 252, the epitaxial layer 254, and the drain 256 can be formed using various types of epitaxy processes and a variety of suitable epitaxial materials. The epitaxial materials can include, for example, silicon, gallium arsenide, and/or other suitable epitaxial materials and combinations thereof. In some examples, the source 252, the epitaxial layer 254, and/or the drain 256 can be doped using suitable n-type or p-type dopants. Ultimately, the source 252 can be used to form a source terminal of a transistor (e.g., after forming a silicide layer and an interconnect on the epitaxial layer, etc.) and the drain 256 can then be used to form a drain terminal of a transistor (e.g., after forming a silicide layer and an interconnect on the epitaxial layer, etc.). The source 252 can be disposed on the channel 240 between the gate 261 and the gate 262, the epitaxial layer 254 can be disposed on the channel 240 between the gate 262 and the gate 263, and the drain 256 can be disposed on the channel 240 between the gate 264 and the gate 265. The source 252, the epitaxial layer 254, and/or the drain 256 can be disposed directly on the channel 240 or there can be some materials and/or layers between the source 252, the epitaxial layer 254, and/or the drain 256 and the channel 240.

In the semiconductor device 200, the gate 262 and the gate 263 can both be implemented as active gates such that the semiconductor device 200 is a multigate (split gate) device. That is, bias voltages that are applied at the gate 262 and the gate 263 can generally control operation and conductance of the semiconductor device 200. Then, in contrast, the gate 261, the gate 264, and the gate 265 can be implemented as "dummy" gates that are not active components of the semiconductor device 200, but can provide advantages in terms of the fabrication process for and the performance of the semiconductor device 200. The gate 261, the gate 264, and the gate 265 can be formed using polysilicon material and/or another suitable material or combination of materials.

The width of the gate 262 (as measured in the direction between the gate 261 and the gate 263 as shown in FIG. 2A) can be greater than the width of the gate 261, the width of the gate 264, and the width of the gate 265. Similarly, the width of the gate 263 (as measured in the direction between the gate 262 and the gate 264 as shown in FIG. 2A) can be greater than the width of the gate 261, the width of the gate 264, and the width of the gate 265. To provide advantages in terms of performance and durability, the width of the gate 262 and the width of the gate 263 can be between 50 nanometers and 360 nanometers, and the width of the gate 261, the width of the gate 264, and the width of the gate 265 can be between 50 nanometers and 100 nanometers. The gate 261, the gate 262, the gate 263, the gate 264, and the gate 265 can be disposed directly on the channel 240 or there can be some materials and/or layers between the gate 261, the gate 262, the gate 263, the gate 264, and the gate 265 and the channel 240 (e.g., gate oxide layers, etc.).

Relative to the semiconductor device 200, some alternate device structures may suffer from durability issues due to factors such as HCI degradation, for example, among other possible factors. The durability issues can cause the overall device performance to degrade over time, and the durability issues can become even more prevalent especially as process node sizes continue to decrease with improvements in semiconductor fabrication technology. Moreover, as a result of process limitations associated with semiconductor fabrication technology (e.g., limitations of semiconductor fabrication plants), some approaches to improving device durability such as, for example, increasing channel length may not be feasible in various applications. However, the specific structure of the semiconductor device 200 can provide advantages in terms of improved durability relative to some alternate structures.

Notably, in the semiconductor device 200, the gate 262 can include and/or can be formed using a first metal, whereas the gate 263 can include and/or can be formed using a second metal that is different from the first metal. The second metal can be different from the first metal such that the gate 262 has a first threshold voltage (V_{T1}) and the gate 263 has a second threshold voltage (V_{T2}), where the second threshold voltage is greater than the first threshold voltage. This variance of the first threshold voltage and the second threshold voltage can alter the current flow and electrical fields within the semiconductor device 200 when compared to some alternate device structures in a manner that improves the durability of the semiconductor device 200. The first threshold voltage and the second threshold voltage can be the threshold bias voltage levels required to be applied to the gate 262 and the gate 263, respectively, to transition the semiconductor device 200 from an off state to an on state (e.g., the voltage levels required for current to flow through the semiconductor device 200).

By increasing the second threshold voltage relative to the first threshold voltage, the durability of the semiconductor device 200 (especially under higher operating voltage conditions) can be improved by reducing the effects of HCI degradation and/or other undesirable degradation effects that may otherwise occur. The second threshold voltage can be altered using the second metal in a variety of suitable manners. For example, the gate 263 can include a work function metal (e.g., the second metal) that increases the second threshold voltage relative to the first threshold voltage. The gate 263 can also be formed using an entirely different metal than the gate 262 in some implementations. The first metal can include molybdenum nitride, molybdenum, aluminum, tungsten nitride, titanium nitride, or tantalum nitride, for example. The second metal likewise can include molybdenum nitride, molybdenum, aluminum, tungsten nitride, titanium nitride, or tantalum nitride, for example. Relative to the semiconductor device 100, the inclusion of the epitaxial layer 254 in the structure of the semiconductor device 200 can provide advantages in certain applications.

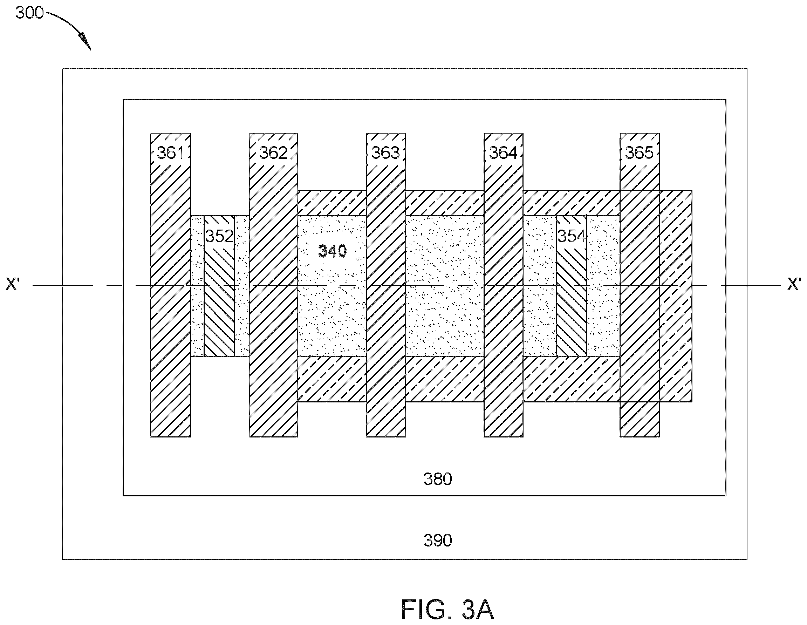

Referring to FIG. 3A, a top view illustrating yet another example semiconductor device 300 is shown, in accordance with some aspects of the disclosure. The semiconductor device 300 can be implemented as a variety of types of semiconductor devices, such as various different types and combinations of transistor structures. For example, the semiconductor device 100 can be a non-planar (three-dimensional) FinFET device such as, for example, an LDMOS device. As shown in FIG. 3A, the semiconductor device 100 includes an example channel 340. The channel 340 can be implemented in a variety of ways using a variety suitable materials and/or combinations of materials. For example, the channel 340 can include a conductive silicon fin in implementations where the semiconductor device 300 is a FinFET device. The channel 340 can also include any other suitable type of conductive fin or other channel-type structure used in the semiconductor device 300. The semiconductor device 300 is also shown to include a plurality of gates including a gate 361, a gate 362, a gate 363, a gate 364, and a gate 365. The semiconductor device 300 is further shown to include a source 352, a drain 354, an oxide diffusion layer 390 (e.g., a thick oxide layer, etc.), and a doped layer 380 (e.g., an N+ buried layer, a deep n-well layer, etc.).

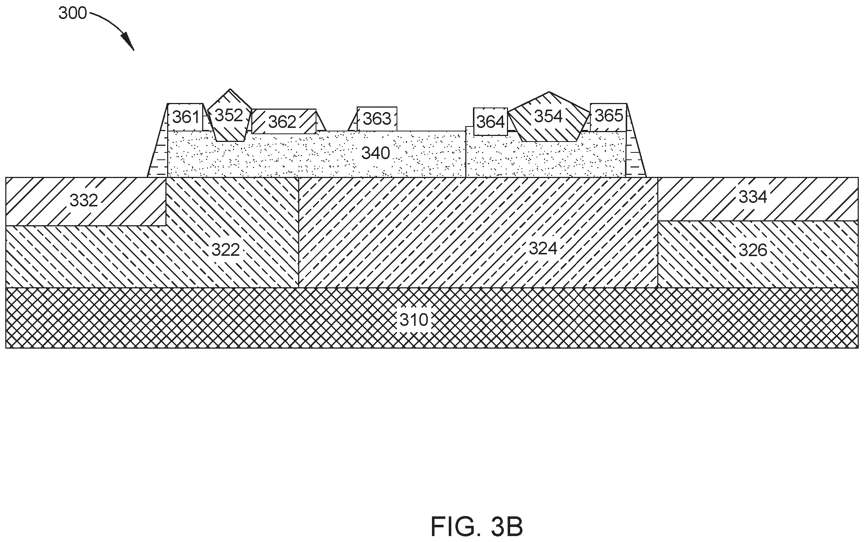

Referring to FIG. 3B, a cross section view illustrating the example semiconductor device 300 is shown, in accordance with some aspects of the disclosure. The illustrated cross section of the semiconductor device 300 as shown in FIG. 3B can be taken along the line X' as shown in FIG. 3A, for example. In the cross section of the semiconductor device 300 as shown in FIG. 3B, the source 352, the drain 354, the gate 361, the gate 362, the gate 363, the gate 364, the gate 365, and the channel 340 can all be seen. In the cross section of the semiconductor device 300 as shown in FIG. 3B, additional layers can also be seen, including a substrate 310, a p-type well 322, an n-type well 324, a p-type well 326, an isolation structure 332, an isolation structure 334, and various oxide layers (e.g., gate oxide layers, etc.) formed around and/or between the source 352, the drain 354, the gate 361, the gate 362, the gate 363, the gate 364, the gate 365, and the channel 340.

The substrate 310 can be formed of silicon material (e.g., crystalline silicon) and/or other suitable materials or combinations of materials. The substrate 310 can be implemented using various fabrication technologies, such as using an SOI structure, a bulk semiconductor structure, an alloy semiconductor, a compound semiconductor, germanium, and/or various other suitable materials and combinations thereof. The substrate 310 can generally provide a base for forming components of the semiconductor device 300 thereon. The semiconductor device 300 can be implemented in a variety of different types of circuits, inducing various types of IC chips built on various types of substrates.

The p-type well 322 and the p-type well 326 can be regions of the semiconductor device 300 that are doped using one or more suitable p-type dopants such as, for example, boron and/or other p-type dopants. The n-type well 324 can be a region of the semiconductor device 300 that is doped using one or more suitable n-type dopants such as arsenic, phosphorous, and/or other n-type dopants. The p-type well 322, the n-type well 324, and the p-type well 326 can be regions of the substrate 310 such that the p-type well 322, the n-type well 324, and the p-type well 326 include doped silicon material, for example. The p-type well 322, the n-type well 324, and the p-type well 326 can also be formed at least partially separate from the substrate 310. For example, the p-type well 322, the n-type well 324, and the p-type well 326 can be formed at least partially within various types of oxide layers and/or other insulating/dielectric layers of the semiconductor device 300. Notably, as shown in FIG. 3B, the gate 363 can be disposed over the n-type well 324. As a result of this structure, the region of the semiconductor device 300 between the gate 363 and the gate 364 can serve as a depletion region. The depletion region within the semiconductor device 300 can deplete charge carriers and thereby limit the amount of current that can flow through the depletion region, enabling the semiconductor device 300 to operate under higher voltage conditions. The doping polarities of the p-type well 322, the n-type well 324, and the p-type well 326 can be reversed in some applications (e.g., to provide a PLDMOS device instead of an LDMOS device).

The isolation structure 332 and the isolation structure 334 can be implemented as STI structures, for example, among other possible types of dielectric layers. The isolation structure 332 and the isolation structure 334 can be formed by etching trenches in the semiconductor device 300. For example, after etching a trench in the p-type well 322, the isolation structure 332 can be formed by depositing a dielectric material at least partially within the trench. The dielectric material used to form the isolation structure 332 and the isolation structure 334 can be, for example, silicon oxide, silicon nitride, and/or other suitable materials and combinations of materials. The isolation structure 332 and the isolation structure 334 can prevent leakage of electric current between various components of the semiconductor device 300, for example.

The source 352 and the drain 354 can be implemented as epitaxial layers as part of the semiconductor device 300. For example, the source 352 and the drain 354 can be formed using various types of epitaxy processes and a variety of suitable epitaxial materials. The epitaxial materials can include, for example, silicon, gallium arsenide, and/or other suitable epitaxial materials and combinations thereof. In some examples, the source 352 and/or the drain 354 can be doped using suitable n-type or p-type dopants. Ultimately, the source 352 can be used to form a source terminal of a transistor (e.g., after forming a silicide layer and an interconnect on the epitaxial layer, etc.) and the drain 354 can be used to form a drain terminal of a transistor (e.g., after forming a silicide layer and an interconnect on the epitaxial layer, etc.). The source 352 can be disposed on the channel 340 between the gate 361 and the gate 362, and the drain 354 can be disposed on the channel 340 between the gate 364 and the gate 365. The source 352 and/or the drain 354 can be disposed directly on the channel 340 or there can be some materials and/or layers between the source 352 and/or the drain 354 and the channel 340.

In the semiconductor device 200, the gate 362 and the gate 363 can both be implemented as active gates such that the semiconductor device 300 is a multigate (split gate) device. That is, bias voltages that are applied at the gate 362 and the gate 363 can generally control operation and conductance of the semiconductor device 300. Then, in contrast, the gate 361, the gate 234, and the gate 365 can be implemented as "dummy" gates that are not active components of the semiconductor device 300, but can provide advantages in terms of the fabrication process for and the performance of the semiconductor device 300. The gate 361, the gate 364, and the gate 365 can be formed using polysilicon material and/or another suitable material or combination of materials.

The width of the gate 362 (as measured in the direction between the gate 361 and the gate 363 as shown in FIG. 3A) can be greater than the width of the gate 361, the width of the gate 364, and the width of the gate 365. Similarly, the width of the gate 363 (as measured in the direction between the gate 362 and the gate 364 as shown in FIG. 3A) can be greater than the width of the gate 361, the width of the gate 364, and the width of the gate 365. To provide advantages in terms of performance and durability, the width of the gate 362 and the width of the gate 363 can be between 50 nanometers and 360 nanometers, and the width of the gate 361, the width of the gate 364, and the width of the gate 365 can be between 50 nanometers and 100 nanometers. The gate 361, the gate 362, the gate 363, the gate 364, and the gate 365 can be disposed directly on the channel 340 or there can be some materials and/or layers between the gate 361, the gate 362, the gate 363, the gate 364, and the gate 365 and the channel 340 (e.g., gate oxide layers, etc.).

Relative to the semiconductor device 300, some alternate device structures may suffer from durability issues due to factors such as HCI degradation, for example, among other possible factors. The durability issues can cause the overall device performance to degrade over time, and the durability issues can become even more prevalent especially as process node sizes continue to decrease with improvements in semiconductor fabrication technology. Moreover, as a result of process limitations associated with semiconductor fabrication technology (e.g., limitations of semiconductor fabrication plants), some approaches to improving device durability such as, for example, increasing channel length may not be feasible in various applications. However, the specific structure of the semiconductor device 300 can provide advantages in terms of improved durability relative to some alternate structures.

Notably, in the semiconductor device 300, the gate 362 can include and/or can be formed using a first metal, whereas the gate 363 can include and/or can be formed using a second metal that is different from the first metal. The second metal can be different from the first metal such that the gate 362 has a first threshold voltage (V_{T1}) and the gate 363 has a second threshold voltage (V_{T2}), where the second threshold voltage is greater than the first threshold voltage. This variance of the first threshold voltage and the second threshold voltage can alter the current flow and electrical fields within the semiconductor device 300 when compared to some alternate device structures in a manner that improves the durability of the semiconductor device 300. The first threshold voltage and the second threshold voltage can be the threshold bias voltage levels required to be applied to the gate 362 and the gate 363, respectively, to transition the semiconductor device 300 from an off state to an on state (e.g., the voltage levels required for current to flow through the semiconductor device 300).

By increasing the second threshold voltage relative to the first threshold voltage, the durability of the semiconductor device 300 (especially under higher operating voltage conditions) can be improved by reducing the effects of HCI degradation and/or other undesirable degradation effects that may otherwise occur. The second threshold voltage can be altered using the second metal in a variety of suitable manners. For example, the gate 363 can include a work function metal (e.g., the second metal) that increases the second threshold voltage relative to the first threshold voltage. The gate 363 can also be formed using an entirely different metal than the gate 362 in some implementations. The first metal can include molybdenum nitride, molybdenum, aluminum, tungsten nitride, titanium nitride, or tantalum nitride, for example. The second metal likewise can include molybdenum nitride, molybdenum, aluminum, tungsten nitride, titanium nitride, or tantalum nitride, for example. Relative to the semiconductor device 100, the absence of a trench and an isolation structure like the trench 170 and the isolation structure 134 in the structure of the semiconductor device 300 can provide advantages in certain applications.

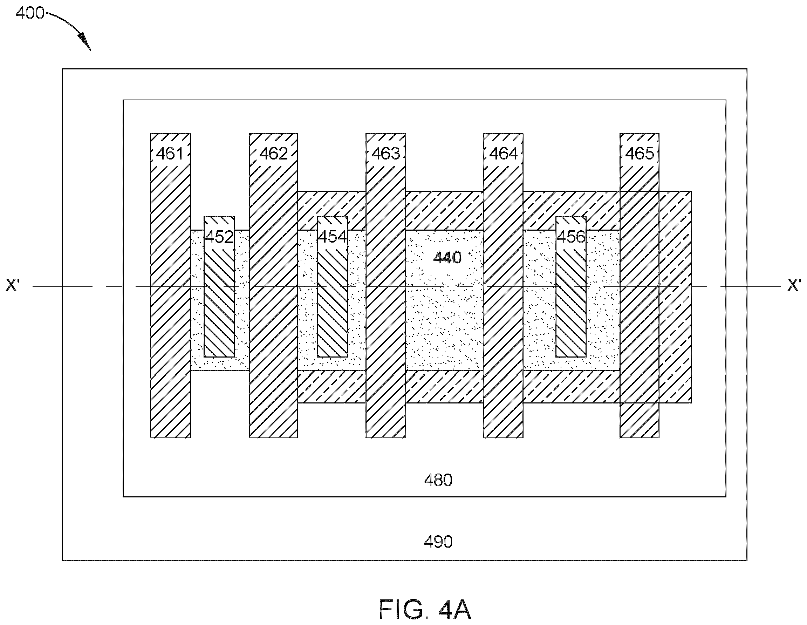

Referring to FIG. 4A, a top view illustrating another example semiconductor device 400 is shown, in accordance with some aspects of the disclosure. The semiconductor device 400 can be implemented as a variety of types of semiconductor devices, such as various different types and combinations of transistor structures. For example, the semiconductor device 400 can be a non-planar (three-dimensional) FinFET device such as, for example, an LDMOS device. As shown in FIG. 4A, the semiconductor device 400 includes an example channel 440. The channel 440 can be implemented in a variety of ways using a variety suitable materials and/or combinations of materials. For example, the channel 440 can include a conductive silicon fin in implementations where the semiconductor device 400 is a FinFET device. The channel 440 can also include any other suitable type of conductive fin or other channel-type structure used in the semiconductor device 400. The semiconductor device 400 is also shown to include a plurality of gates including a gate 461, a gate 462, a gate 463, a gate 464, and a gate 465. The semiconductor device 400 is further shown to include a source 452, an epitaxial layer 454, a drain 456, an oxide diffusion layer 490 (e.g., a thick oxide layer, etc.), and a doped layer 480 (e.g., an N+ buried layer, a deep n-well layer, etc.).

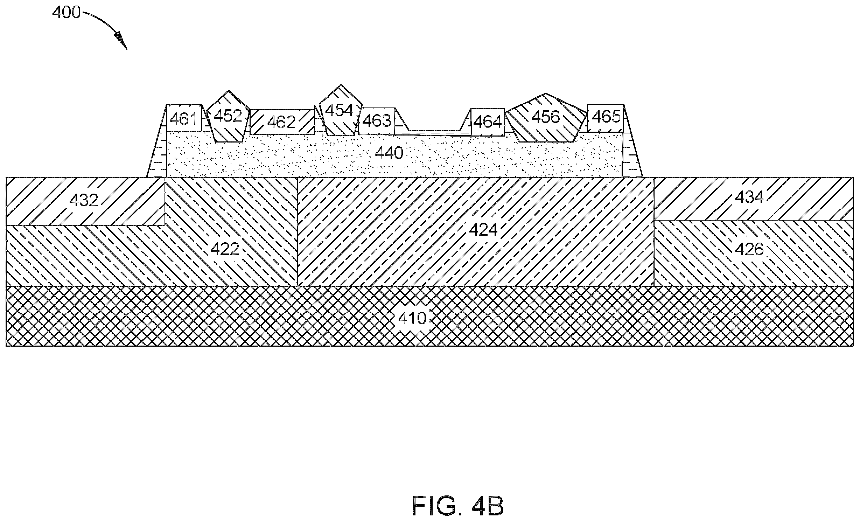

Referring to FIG. 4B, a cross section view illustrating the example semiconductor device 400 is shown, in accordance with some aspects of the disclosure. The illustrated cross section of the semiconductor device 400 as shown in FIG. 4B can be taken along the line X' as shown in FIG. 4A, for example. In the cross section of the semiconductor device 400 as shown in FIG. 4B, the source 452, the epitaxial layer 454, the drain 456, the gate 461, the gate 462, the gate 463, the gate 464, the gate 465, and finally the channel 440 can all be seen. In the cross section of the semiconductor device 400 as shown in FIG. 4B, additional layers can also be seen, including a substrate 410, a p-type well 422, an n-type well 424, a p-type well 426, an isolation structure 432, an isolation structure 434, and various oxide layers (e.g., gate oxide layers, etc.) formed around and/or between the source 452, the epitaxial layer 454, the drain 456, the gate 461, the gate 462, the gate 463, the gate 464, the gate 465, and the channel 440.

The substrate 410 can be formed of silicon material (e.g., crystalline silicon) and/or other suitable materials or combinations of materials. The substrate 410 can be implemented using various fabrication technologies, such as using an SOI structure, a bulk semiconductor structure, an alloy semiconductor, a compound semiconductor, germanium, and/or various other suitable materials and combinations thereof. The substrate 410 can generally provide a base for forming components of the semiconductor device 400 thereon. The semiconductor device 400 can be implemented in a variety of different types of circuits, inducing various types of IC chips built on various types of substrates.

The p-type well 422 and the p-type well 426 can be regions of the semiconductor device 400 that are doped using one or more suitable p-type dopants such as, for example, boron and/or other p-type dopants. The n-type well 424 can be a region of the semiconductor device 400 that is doped using one or more suitable n-type dopants such as arsenic, phosphorous, and/or other n-type dopants. The p-type well 422, the n-type well 424, and the p-type well 426 can be regions of the substrate 410 such that the p-type well 422, the n-type well 424, and the p-type well 426 include doped silicon material, for example. The p-type well 422, the n-type well 424, and the p-type well 426 can also be formed at least partially separate from the substrate 410. For example, the p-type well 422, the n-type well 424, and the p-type well 426 can be formed at least partially within various types of oxide layers and/or other insulating/dielectric layers of the semiconductor device 400. Notably, as shown in FIG. 4B, the gate 463 can be disposed over the n-type well 424. As a result of this structure, the region of the semiconductor device 400 between the gate 463 and the gate 464 can serve as a depletion region. The depletion region within the semiconductor device 400 can deplete charge carriers and thereby limit the amount of current that can flow through the depletion region as well as enable the semiconductor device 400 to operate under higher voltage conditions. The doping polarities of the p-type well 422, the n-type well 424, and the p-type well 426 can be reversed in some applications (e.g., to provide a PLDMOS device instead of an LDMOS device).

The isolation structure 432 and the isolation structure 434 can be implemented as STI structures, for example, among other possible types of dielectric layers. The isolation structure 432 and the isolation structure 434 can be formed by etching trenches in the semiconductor device 400. For example, after etching a trench in the p-type well 422, the isolation structure 432 can be formed by depositing a dielectric material at least partially within the trench. The dielectric material used to form the isolation structure 432 and the isolation structure 434 can be, for example, silicon oxide, silicon nitride, and/or other suitable materials and combinations of materials. The isolation structure 432 and the isolation structure 434 can prevent leakage of electric current between various components of the semiconductor device 400, for example.

The source 452 and the drain 456 can be implemented as epitaxial layers as part of the semiconductor device 400, along with the epitaxial layer 454. The source 452, the epitaxial layer 454, and the drain 456 can be formed using various types of epitaxy processes and a variety of suitable epitaxial materials. The epitaxial materials can include, for example, silicon, gallium arsenide, and/or other suitable epitaxial materials and combinations thereof. In some examples, the source 452, the epitaxial layer 454, and/or the drain 456 can be doped using suitable n-type or p-type dopants. Ultimately, the source 452 can be used to form a source terminal of a transistor (e.g., after forming a silicide layer and an interconnect on the epitaxial layer, etc.) and the drain 456 can then be used to form a drain terminal of a transistor (e.g., after forming a silicide layer and an interconnect on the epitaxial layer, etc.). The source 452 can be disposed on the channel 440 between the gate 461 and the gate 462, the epitaxial layer 454 can be disposed on the channel 440 between the gate 462 and the gate 463, and the drain 456 can be disposed on the channel 440 between the gate 464 and the gate 465. The source 452, the epitaxial layer 454, and/or the drain 456 can be disposed directly on the channel 440 or there can be some materials and/or layers between the source 452, the epitaxial layer 454, and/or the drain 456 and the channel 440.

In the semiconductor device 400, the gate 462 and the gate 463 can both be implemented as active gates such that the semiconductor device 400 is a multigate (split gate) device. That is, bias voltages that are applied at the gate 462 and the gate 463 can generally control operation and conductance of the semiconductor device 400. Then, in contrast, the gate 461, the gate 464, and the gate 465 can be implemented as "dummy" gates that are not active components of the semiconductor device 400, but can provide advantages in terms of the fabrication process for and the performance of the semiconductor device 400. The gate 461, the gate 464, and the gate 465 can be formed using polysilicon material and/or another suitable material or combination of materials.

The width of the gate 462 (as measured in the direction between the gate 461 and the gate 463 as shown in FIG. 4A) can be greater than the width of the gate 461, the width of the gate 464, and the width of the gate 465. Similarly, the width of the gate 463 (as measured in the direction between the gate 462 and the gate 464 as shown in FIG. 4A) can be greater than the width of the gate 461, the width of the gate 464, and the width of the gate 465. To provide advantages in terms of performance and durability, the width of the gate 462 and the width of the gate 463 can be between 50 nanometers and 360 nanometers, and the width of the gate 461, the width of the gate 464, and the width of the gate 465 can be between 50 nanometers and 100 nanometers. The gate 461, the gate 462, the gate 463, the gate 464, and the gate 465 can be disposed directly on the channel4240 or there can be some materials and/or layers between the gate 461, the gate 462, the gate 463, the gate 464, and the gate 465 and the channel 440 (e.g., gate oxide layers, etc.).

Relative to the semiconductor device 400, some alternate device structures may suffer from durability issues due to factors such as HCI degradation, for example, among other possible factors. The durability issues can cause the overall device performance to degrade over time, and the durability issues can become even more prevalent especially as process node sizes continue to decrease with improvements in semiconductor fabrication technology. Moreover, as a result of process limitations associated with semiconductor fabrication technology (e.g., limitations of semiconductor fabrication plants), some approaches to improving device durability such as, for example, increasing channel length may not be feasible in various applications. However, the specific structure of the semiconductor device 400 can provide advantages in terms of improved durability relative to some alternate structures.

Notably in the semiconductor device 400, the gate 462 can include and/or can be formed using a first metal, whereas the gate 463 can include and/or can be formed using a second metal that is different from the first metal. The second metal can be different from the first metal such that the gate 462 has a first threshold voltage (V_{T1}) and the gate 463 has a second threshold voltage (V_{T2}), where the second threshold voltage is greater than the first threshold voltage. This variance of the first threshold voltage and the second threshold voltage can alter the current flow and electrical fields within the semiconductor device 400 when compared to some alternate device structures in a manner that improves the durability of the semiconductor device 400. The first threshold voltage and the second threshold voltage can be the threshold bias voltage levels required to be applied to the gate 462 and the gate 463, respectively, to transition the semiconductor device 400 from an off state to an on state (e.g., the voltage levels required for current to flow through the semiconductor device 400).

By increasing the second threshold voltage relative to the first threshold voltage, the durability of the semiconductor device 400 (especially under higher operating voltage conditions) can be improved by reducing the effects of HCI degradation and/or other undesirable degradation effects that may otherwise occur. The second threshold voltage can be altered using the second metal in a variety of suitable manners. For example, the gate 463 can include a work function metal (e.g., the second metal) that increases the second threshold voltage relative to the first threshold voltage. The gate 463 can also be formed using an entirely different metal than the gate 462 in some implementations. The first metal can include molybdenum nitride, molybdenum, aluminum, tungsten nitride, titanium nitride, or tantalum nitride, for example. The second metal likewise can include molybdenum nitride, molybdenum, aluminum, tungsten nitride, titanium nitride, or tantalum nitride, for example. Relative to the semiconductor device 100, the inclusion of the epitaxial layer 454 and the absence of a trench and an isolation structure like the trench 170 and the isolation structure 134 in the structure of the semiconductor device 400 can provide advantages in certain applications.

## Claims

1. A semiconductor device, comprising:
a channel;
a source disposed on the channel;
a drain disposed on the channel;
a first gate comprising a first metal disposed on the channel between the source and the drain; and
a second gate comprising a second metal disposed on the channel between the first gate and the drain, the second metal being different from the first metal.

2. Semiconductor device according to claim 1, wherein the second metal is different from the first metal such that the first gate has a first threshold voltage and the second gate has a second threshold voltage, the second threshold voltage being greater than the first threshold voltage.

3. Semiconductor device according to claim 1 or claim 2, wherein the second gate is disposed over an n-type well.

4. Semiconductor device according to one of the preceding claims, comprising a trench formed in the channel between the second gate and the drain.

5. Semiconductor device according to claim 4, wherein the trench is disposed over an n-type well.

6. Semiconductor device according to one of the preceding claims, wherein:
the first gate comprises a first active gate;
the second gate comprises a second active gate; and
the semiconductor device comprises a dummy gate disposed on the channel between the second gate and the drain.

7. Semiconductor device according to claim 6, wherein:
a width of the first gate is between 50 nanometers and 360 nanometers;
a width of the second gate is between 50 nanometers and 360 nanometers; and
a width of the dummy gate is less than the width of the first gate and the width of the second gate; and
the width of the dummy gate is between is between 50 nanometers and 100 nanometers.

8. Semiconductor device according to one of the preceding claims, comprising an epitaxial layer disposed on the channel between the first gate and the second gate.

9. Semiconductor device according to one of the preceding claims, wherein:
the first metal comprises molybdenum nitride, molybdenum, aluminum, tungsten nitride, titanium nitride, or tantalum nitride; and
the second metal comprises molybdenum nitride, molybdenum, aluminum, tungsten nitride, titanium nitride, or tantalum nitride.

10. Semiconductor device according to one of the preceding claims, wherein:
the channel comprises a silicon fin; and
the semiconductor device comprises a fin field-effect transistor (FinFET).

11. The semiconductor device according to one of the preceding claims, wherein:
the second gate is disposed over an n-type well;
the channel comprises a silicon fin;
the first metal comprises molybdenum nitride, molybdenum, aluminum, tungsten nitride, titanium nitride, or tantalum nitride;
the second metal comprises molybdenum nitride, molybdenum, aluminum, tungsten nitride, titanium nitride, or tantalum nitride; and
the semiconductor device comprises a fin field-effect transistor (FinFET).

12. Semiconductor device according to one of the preceding claims, further comprising:
a third gate disposed on the channel between the second gate and the drain.

13. The semiconductor device of claim 12, wherein:
the first gate comprises a first active gate;
the second gate comprises a second active gate; and
the third gate comprises a dummy gate disposed on the channel between the second gate and the drain.

14. The semiconductor device according to claim 12 or claim 13, wherein:
a width of the first gate is between 50 nanometers and 360 nanometers;
a width of the second gate is between 50 nanometers and 360 nanometers; and
a width of the third gate is less than the width of the first gate and the width of the second gate; and
the width of the third gate is between is between 50 nanometers and 100 nanometers.
